# EUROPEAN PATENT SPECIFICATION

(11) **EP 2 389 049 B1**
(45) Date of publication and mention of the grant of the patent: **06.03.2013**
(21) Application number: 11158346.4
(22) Date of filing: 15.03.2011
(51) Int. Cl.: H05K 1/14, H05K 1/18, H01L 23/538, H01L 23/498

(54) **Multilayer printed circuit board using flexible interconnect structure, and method of making same**
Mehrschichtige gedruckte Leiterplatte mit flexibler Anschlussstruktur und Herstellungsverfahren dafür
Carte de circuit imprimé multicouche utilisant une structure d'interconnexion flexible et son procédé de fabrication

(30) Priority: 21.05.2010 JP 2010117011
(43) Date of publication of application: 23.11.2011
(73) Proprietor: FUJITSU LIMITED, Kawasaki-shi, Kanagawa 211-8588 (JP)
(72) Inventor: Kanai, Ryo, Kawasaki-shi Kanagawa 211-8588 (JP); Kikuchi, Shunichi, Kawasaki-shi Kanagawa 211-8588 (JP); Nakamura, Naoki, Kawasaki-shi Kanagawa 211-8588 (JP); Sugino, Shigeru, Kawasaki-shi Kanagawa 211-8588 (JP); Hatanaka, Kiyoyuki, Kawasaki-shi Kanagawa 211-8588 (JP); Taketomi, Nobuo, Kawasaki-shi Kanagawa 211-8588 (JP)
(74) Representative: Holz, Ulrike

(56) References cited:
- US-A- 5 426 263
- US-A1- 2007 262 470

## Description

### FIELD

The disclosures herein relate to a multilayer printed circuit board and a method of making the multilayer printed circuit board.

### BACKGROUND

There has been a trend to miniaturize electronic devices. To achieve such miniaturization, the constituent elements of electronic devices have been required to consume less space. Patent Document 1 discloses a structure which includes an embedded semiconductor module. This structure provides electrical connections for a semiconductor chip directly through pin electrodes. Patent Document 2 discloses a structure in which an upper circuit substrate and a lower circuit substrate are connected to each other through a semiconductor package.

Semiconductor chips are also required to have smaller electrodes arranged at shorter intervals in order to cope with further miniaturization and an increase in the number of input and output signals. Because of this, electrodes provided on a mounting board are also required to be smaller and arranged at shorter intervals. This results in wiring density being increased on a mounting board, which increases difficulties in manufacturing, thereby reducing a yield rate. In the case of the related-art technologies described above, there is a limit to wiring density achievable on a mounting board due to structural reasons.

It may thus be desirable to overcome this problem. There may be a need for a multilayer printed circuit board in which interconnection areas for a semiconductor package can be expanded without structurally-imposed restrictions on the positions of terminals. There may also be a need for a method of making such a multilayer printer circuit board.
[Patent Document 1] Japanese Laid-open Patent Publication No. 2005-39227
[Patent Document 2] Japanese Laid-open Patent Publication No. 2004-363566

US5426263 A refers to an electronic assembly having a double-sided leadless component and one or more printed circuit boards. The component has a plurality of electrical terminations or pads on both opposing major surfaces. Each of the printed circuit boards has a printed circuit pattern that has a plurality of pads that correspond to the electrical terminations on both sides of the double-sided leadless component. The electrical terminals on one side of the component are attached to the pads on the first substrate and the electrical terminals on the other side of the leadless component are attached to the pads on the second substrate. The printed circuit boards are joined together to form a multilayered circuit board so that the double-sided leadless component is buried or recessed inside. The component is attached to the pads of the printed circuit board using solder.

US2007262470 A1 refers to a module with a built-in semiconductor. In the module with a built-in semiconductor, a semiconductor device is contained in an interlayer connection member located between a first wiring board and a second wiring board. The back side of the semiconductor device is die-bonded to the first wiring board via an adhesive, and the semiconductor device is connected electrically to the second wiring pattern via a protruding electrode.

### SUMMARY

According to an aspect of the embodiment, a multilayer printed circuit board includes an interior interconnect layer, and a semiconductor package embedded within the said multilayer printed circuit board, characterized in that it includes a rigid interconnect structure connected to a semiconductor chip and a flexible interconnect structure whose distal end is a free end, wherein the rigid interconnect structure and the flexible interconnect structure constitute a rigid-flex substrate and wherein the flexible interconnect structure and the interior interconnect layer are electrically connected to each other.

According to another aspect, a method of making a multilayer printed circuit board including an interior interconnect layer includes placing a semiconductor package on a substrate having a conductive pad formed thereon such that the semiconductor package is aligned with the conductive pad, the semiconductor package including a rigid interconnect structure connected to a semiconductor chip and a flexible interconnect structure whose distal end is a free end; wherein the rigid interconnect structure and the flexible interconnect structure constitute a rigid-flex substrate, and providing an insulating layer around the semiconductor package; and providing an electrical connection between the flexible interconnect structure and the interior interconnect layer formed on the insulating layer.

### BRIEF DESCRIPTION OF DRAWINGS

Fig. 1 is a cross-sectional view of a semiconductor package according to a first embodiment;
Fig. 2 is a cross-sectional view of a semiconductor package according to a second embodiment;
Fig. 3 is a cross-sectional view of a semiconductor package according to a third embodiment;
Fig. 4 is a cross-sectional view of a semiconductor package according to a fourth embodiment;
Fig. 5 is a drawing illustrating a process step in a method of making a printed circuit board according to a fifth embodiment;
Fig. 6 is a drawing illustrating a process step in the method of making a printed circuit board according to the fifth embodiment;
Fig. 7 is a drawing illustrating a process step in the method of making a printed circuit board according to the fifth embodiment;
Fig. 8 is a top perspective view of a structure obtained by placing a flexible interconnect structure on an insulating layer in the method of making a printed circuit board according to the fifth embodiment;
Fig. 9 is a drawing illustrating a process step in a method of making a printed circuit board according to a sixth embodiment;
Fig. 10 is a drawing illustrating a process step in the method of making a printed circuit board according to the sixth embodiment;
Fig. 11 is a drawing illustrating a process step in the method of making a printed circuit board according to the sixth embodiment; and
Fig. 12 is a drawing illustrating a process step in the method of making a printed circuit board according to the sixth embodiment.

### DESCRIPTION OF EMBODIMENTS

In the following, embodiments will be described with reference to the accompanying drawings.

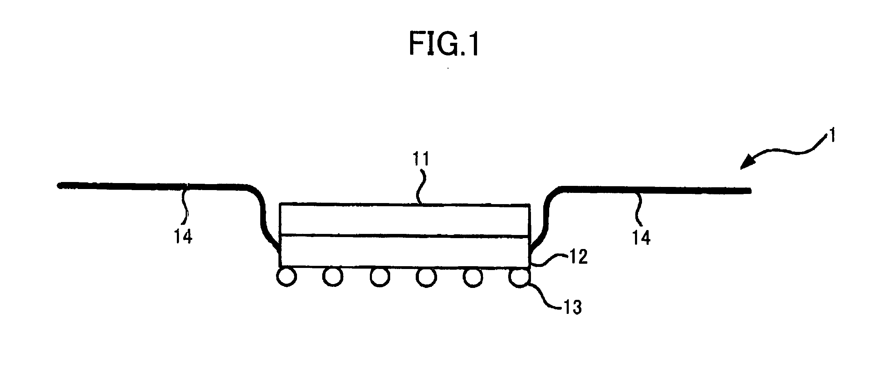

Fig. 1 is a cross-sectional view of a semiconductor device (i.e., semiconductor package) 1 according to a first embodiment. As illustrated in Fig. 1, a semiconductor package 1 includes a semiconductor chip 11, an interconnect structure 12, terminals 13, and flexible interconnect structures 14. In the present embodiment, the rigid interconnect structure 12 and the flexible interconnect structures 14 together constitute a rigid-flex substrate as will be described later. In the present embodiment, the semiconductor chip 11 is connected to the upper face of the rigid interconnect structure 12. The semiconductor chip 11 may be a semiconductor chip provided alone, or may be a structure in which one or more semiconductor chips are sealed with encapsulant material. The packaging structure may be a BGA (ball grid array) structure or a CSP (chip size package) structure, for example. At least one of an insulating layer and a conductive layer of the rigid interconnect structure 12 is arranged alternately with the insulating and conductive layers of the flexible interconnect structures 14, thereby constituting a rigid-flex substrate. In the following, each structure will be described.

The rigid interconnect structure 12 is connected to the semiconductor chip 11, and serves as a package substrate for connection with a semiconductor-embedded printed circuit board, which will be described later. As illustrated in Fig. 1, the semiconductor chip 11 is placed on a face of the rigid interconnect structure 12 that is parallel to an insulating layer thereof. The terminals 13 are arranged on the other face of the rigid interconnect structure 12. The rigid interconnect structure 12 may include one or more insulating layers and one or more conductive layers. These layers are arranged alternately with one or more insulating layers and one or more conductive layers of the flexible interconnect structures 14, thereby constituting a rigid-flex substrate. The one or more insulating layers of the rigid interconnect structure 12 is made of resin, which may be a hard material such as glass epoxy. When the rigid interconnect structure 12 includes plural conductive layers, there is a structure inside the rigid interconnect structure 12 to provide electrical connections between these conductive layers. The rigid interconnect structure 12 may have a single-layer structure comprised of a single conductive layer or a multilayer structure comprised of plural conductive layers.

The terminals 13 are formed on the face of the rigid interconnect structure 12, and serve as electrodes of the rigid-flex substrate. The terminals 13 also serve as terminals for connection with a mounting board, which will be described later. The terminals 13 may be conductive structures such as solder balls or metal bumps like Au bumps, for example, which are attached on electrode pads of the rigid interconnect structure 12.

Each of the flexible interconnect structures 14 may also include one or more conductive layers and one or more insulating layers. Electrodes formed on the flexible interconnect structures 14 serve as electrodes of the rigid-flex substrate as do the terminals 13 of the rigid interconnect structure 12. A portion of the flexible interconnect structures 14 is integrated into the rigid interconnect structure 12 as part of the combined multilayer structure, thereby forming part of the rigid-flex substrate. Each flexible interconnect structure 14 extends outwardly from a lateral face (i.e., side end) of the rigid interconnect structure 12. The distal end of the flexible interconnect structure 14 is kept in an open state, i.e., a free end. The rigid interconnect structure 12 may include only insulating layers, and the flexible interconnect structure 14 may be a single-conductive-layer structure. In such a case, the flexible interconnect structure 14 is placed between the insulating layers of the rigid interconnect structure 12, so that the rigid-flex substrate as a whole is a single-layer structure. The lateral faces of the rigid interconnect structure 12 are the faces that are perpendicular to the face on which the semiconductor chip 11 is mounted. With this arrangement, the flexible interconnect structures 14 extend outwardly from the semiconductor chip 11 as illustrated in Fig. 1.

Each flexible interconnect structure 14 may include only one conductive layer, or may include plural conductive layers. When the rigid interconnect structure 12 has a multilayer structure, each flexible interconnect structure 14 is placed between layers of the rigid interconnect structure 12 to form part of the multilayer structure. The flexible interconnect structures 14 illustrated in Fig. 1 may be formed as a unitary integral piece. In such a case, a center portion of the flexible interconnect structure 14 may be placed between insulating layers of the rigid interconnect structure 12 to form part of the multilayer structure. Alternatively, the flexible interconnect structures 14 illustrated in Fig. 1 may be separate pieces. In such a case, the flexible interconnect structures 14 may be integrated into the rigid interconnect structure 12 in the same layer or separately in different layers to form part of the multilayer structure. Namely, these flexible interconnect structures 14 may be situated one over another without connection therebetween. In any one of these different arrangements, a portion of the flexible interconnect structure 14 is exposed and extend from a side face of the rigid interconnect structure 12, such that the distal end of the flexible interconnect structure 14 is kept in an open state. Here, the fact that the distal end is kept in an open state means that the distal end of the flexible interconnect structure 14 is a free end, which is capable of a free movement to bend the flexible interconnect structure 14 in an unrestricted manner. There may be another flexible interconnect structure 14, on which a semiconductor chip 11 is mounted. Further, as in the example illustrated in Fig. 1, all the flexible interconnect structures 14 may extend from the rigid interconnect structure 12, with their distal ends kept in an open state. A portion of the multilayer structure which includes both the flexible interconnect structure 14 and the rigid interconnect structure 12 has one or more inter-layer vias to connect between these interconnect structures.

The flexible interconnect structure 14 may include one or more insulating films having a thickness of 12 to 50 micrometers and one or more conductive foils having a thickness of 12 to 50 micrometers, which are arranged one over another. The insulating film may be a polyimide film, a polyethylene film, or the like. The flexible interconnect structure 14 which is formed of these materials can bend repeatedly. Placement of the flexible interconnect structure 14 can thus be tried and changed as many times as needed. The larger the area size of the flexible interconnect structure 14, the greater latitude in the placement of the flexible interconnect structure 14. This area size may be determined by taking into account the size of the semiconductor package 1.

As described above, the rigid-flex substrate has the distal end of the flexible interconnect structure 14 kept in an open state. The interconnect area of the semiconductor package 1 can thus be as wide as the area which the flexible interconnect structure 14 can reach. The flexible interconnect structure 14 serves as terminals to provide electrical connections between the semiconductor package 1 and external devices. When there is a need to increase the number of terminals of the semiconductor package 1, the number of terminals of the semiconductor package 1 can be freely selected within the limit imposed by conditions relating to mounting and manufacturing. Since the flexible interconnect structure 14 serves as terminals to provide electrical connections with external devices, sufficient margin may be provided to the size and pitches of the terminals 13 of the rigid interconnect structure 12 despite an increase in the number of terminals of the semiconductor package 1. Accordingly, the use of the semiconductor package 1 makes it possible to avoid difficulties in manufacturing, such as the difficulties to increase the number of terminal pins, miniaturize interconnect lines, and shorten their pitches. A multilayer printed circuit board including an embedded semiconductor device may thus be easily manufactured.

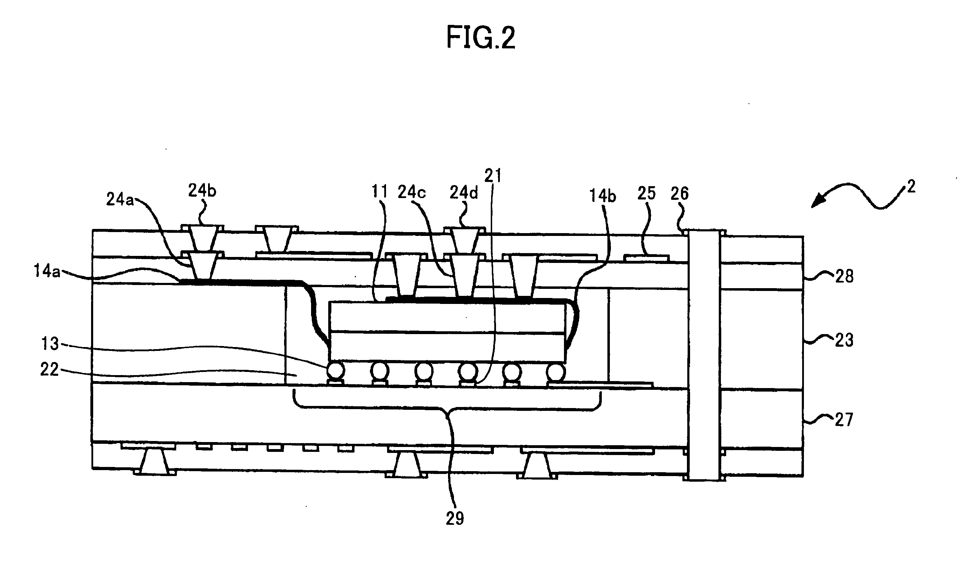

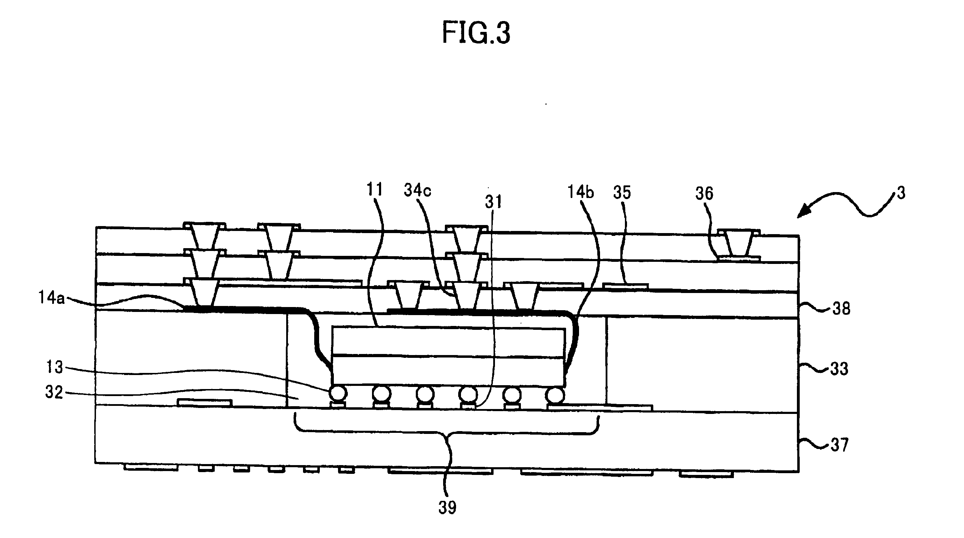

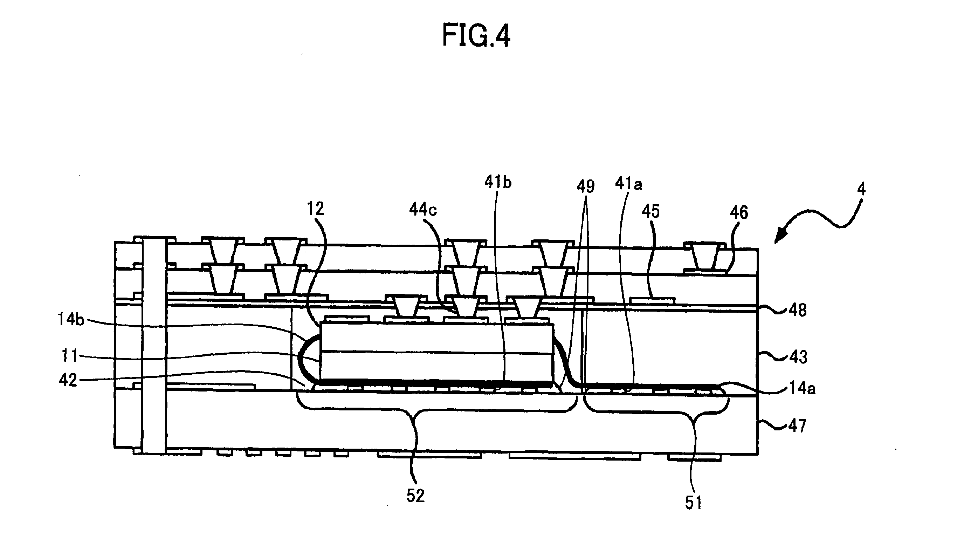

In the following, a multilayer printed circuit board having the semiconductor package 1 embedded therein (hereinafter referred to simply as a "printed circuit board" for the sake of convenience) will be described by referring to Fig. 2 through Fig. 4. Fig. 2 is a cross-sectional view of a printed circuit board 2 according to a second embodiment. Fig. 3 is a cross-sectional view of a printed circuit board 3 according to a third embodiment. Fig. 4 is a cross-sectional view of a printed circuit board 4 according to a fourth embodiment. As illustrated in Fig. 2, the printed circuit board 2 includes the semiconductor package 1, terminal pads 21, a sealing member 22, and vias 24a, 24b, 24c, and 24d. As illustrated in Fig. 3, the printed circuit board 3 includes the semiconductor package 1, terminal pads 31, a sealing member 32, and vias 34c. As illustrated in Fig. 4, the printed circuit board 4 includes the semiconductor package 1, terminal pads 41a and 41b, a sealing member 42, and vias 44c. In the following, each structure will be described.

As illustrated in Fig. 2 and Fig. 3, the terminal pads 21 and 31 are placed in container areas 29 and 39, respectively, where the semiconductor package 1 is situated. The terminal pads 21 and 31 are connected to the terminals 13 of the rigid interconnect structure 12 through solder bonding, for example. As illustrated in Fig. 4, the terminal pads 41b are placed in a container area 52 where the semiconductor package 1 is situated. The terminal pads 41b are connected by use of anisotropic conductive adhesive to a flexible interconnect structure 14b extending from the rigid interconnect structure 12. As illustrated in Fig. 4, the terminal pads 41a are placed in an area 51 that is outside the container area 52 in which the semiconductor package 1 is situated. The terminal pads 41a are connected by use of anisotropic conductive adhesive to a flexible interconnect structure 14a of the semiconductor package 1. The sealing members 22, 32, and 42 seal the semiconductor package 1, and are surrounded by insulating layers 23, 33, and 43, respectively. The sealing members 22, 32, and 42 may be made of an epoxy resin material, a thermosetting resin material, a thermoplastic resin material, or the like. The insulating layers 23, 33, and 43 may be made of resin, pre-preg (i.e., pre-impregnated material), or the like. Insulating layers 28, 38, and 48 situated above the container areas 29, 39, and 52 may be made of resin, pre-preg, resin-coated copper foil, or the like. The material used to form the insulating layers 23, 33, 43, 28, 38, and 48 may be used as the sealing members 22, 32, and 42. Alternatively, the flow of resin or pre-embedded resin used to form the insulating layers 23, 33, 43, 28, 38, and 48 may be utilized to form the sealing members 22, 32, and 42. The vias 24a and the like will later be described. In the following, the printed circuit boards 2 through 4 will each be described.

In the printed circuit board 2 of the second embodiment, one of the flexible interconnect structures 14 (hereinafter referred to as a "first flexible interconnect structure 14a") is placed on the insulating layer 23, and the other of the flexible interconnect structures 14 (hereinafter referred to as a "second flexible interconnect structure 14b") is placed on the semiconductor chip 11. The first flexible interconnect structure 14a is connected to an interior interconnect layer 25 and a surface interconnect layer 26 through the vias 24a and 24b. The second flexible interconnect structure 14b is placed on the semiconductor chip 11 and sealed with the sealing member 22. The second flexible interconnect structure 14b is connected to the interior interconnect layer 25 through the vias 24c passing through the sealing member 22, and is further connected to the surface interconnect layer 26 through the via 24d. The interior interconnect layer 25 is also connected to other devices and the like (now shown) in addition to the semiconductor package 1. These devices and the like may be situated on the insulating layer 27 situated below the container area 29. The printed circuit board 2 has superior heat dissipation characteristics because of its structure in which the vias 24c are situated close to the semiconductor chip 11, allowing heat from the semiconductor chip 11 to transmit to outside through the vias 24c and 24d and the like.

In the printed circuit board 3 of the third embodiment, the first flexible interconnect structure 14a is placed on the insulating layer 33. The semiconductor chip 11 is then sealed with the sealing member 32, with a portion of the second flexible interconnect structure 14b exposed outside the sealing member 32. The second flexible interconnect structure 14b is placed on top of the sealing member 32. After the insulating layer 38 is placed, the vias 34c and interior interconnect layers 35 and 36 are formed. The interior interconnect layers 35 and 36 are connected to the first flexible interconnect structure 14a and the second flexible interconnect structure 14b. Other than the arrangement of the second flexible interconnect structure 14b, the structure of the printed circuit board 3 is the same as or similar to the structure of the printed circuit board 2 of the second embodiment. The printed circuit board 3 has superior heat dissipation characteristics because of its structure in which the vias 34c are situated close to the semiconductor chip 11, allowing heat from the semiconductor chip 11 to transmit to outside through the sealing member 32 and the vias 34c. The arrangement of the vias may be determined according to the arrangement of the first flexible interconnect structure 14a and the second flexible interconnect structure 14b. Accordingly, the semiconductor package 1 may be easily implemented without restrictions imposed by the specifics of interconnect lines on the insulating layer 37.

In the printed circuit board 4 of the fourth embodiment, the semiconductor chip 11 of the semiconductor package 1 is placed to face an insulating layer 47 situated under the container area 52. The second flexible interconnect structure 14b is coupled through a conductive member 49 to the terminals 41b situated in the container area 52. Further, the first flexible interconnect structure 14a is coupled through a conductive member 49 to the terminals 41a situated in the area 51 of the insulating layer 47. The conductive member 49 may provide electrical connections through anisotropic conductive paste, anisotropic conductive adhesive, an anisotropic conductive film, metal bumps, solder, or the like. The rigid interconnect structure 12 is connected to an interior interconnect layer 45 and the like via the vias 44c.

As described above, the printed circuit boards 2 through 4 of the second through fourth embodiments use the semiconductor package 1 that has the flexible interconnect structures 14. The design of interconnect patterns in the printed circuit board is thus not restricted by the positions of terminals. The flexible interconnect structures 14 has openings through an insulating layer that serve as terminals for electrical connection. The flexible interconnect structures 14 can thus serve as terminals to replace the terminals 13, thereby helping to avoid the shortening of pitches of the terminals 13.

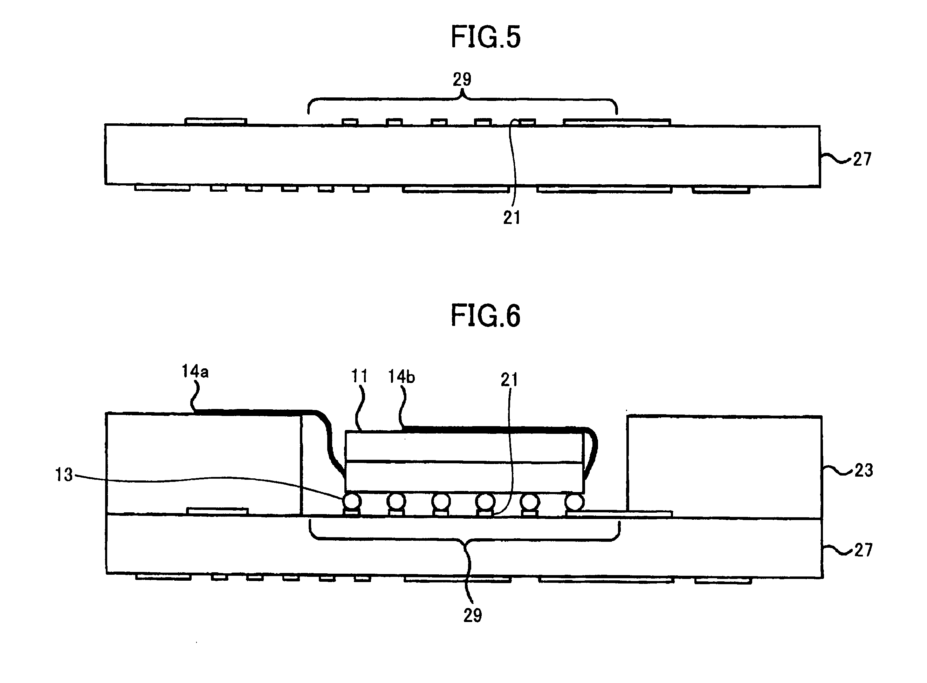

In the following, a description will be given of a method of making a printed circuit board according to a fifth embodiment. Fig. 5 through Fig. 7 are drawings illustrating the steps of manufacturing the printed circuit board according to the present embodiment.

As illustrated in Fig. 5, interconnect patterns inclusive of the terminal pads 21 that are to be connected to the semiconductor package 1 are formed on the insulating layer 27. The terminal pads 21 are arranged in the container area 29 for the semiconductor package 1. Although not illustrated, the element 27 may be a single insulating layer with conductive bodies on the front and back surfaces thereof electrically connectable through vias, or may be a structure including plural insulating layers and conductive layers with internal electrical connections.

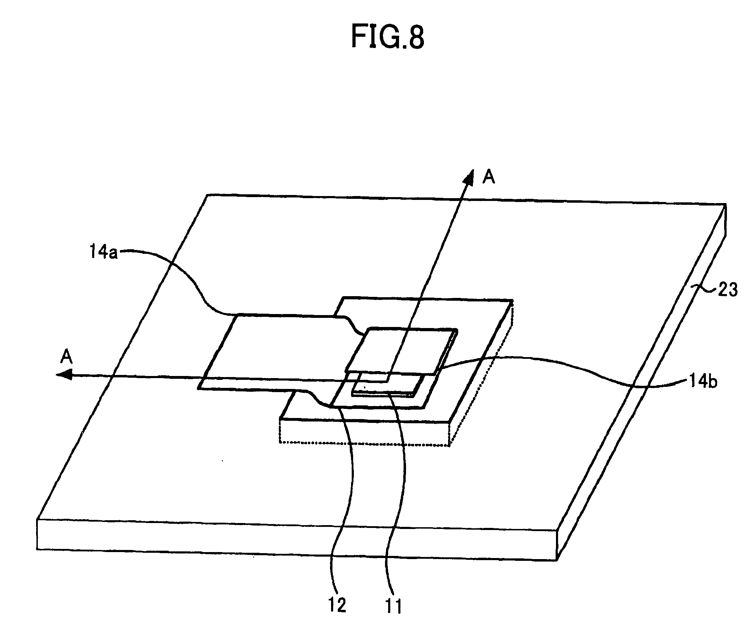

As illustrated in Fig. 6, the semiconductor package 1 is placed on the insulating layer 27 while aligning the terminals 13 of the semiconductor package 1 with the terminal pads 21. The semiconductor package 1 is then fixedly mounted by solder bonding or the like. The insulating layer 23 is then provided around the semiconductor package 1. Although not illustrated, the layer 23 may be a single insulating layer, or may be a structure including plural insulating layers and conductive layers with internal electrical connections. The first flexible interconnect structure 14a is placed on the insulating layer 23. The second flexible interconnect structure 14b is placed on the semiconductor chip 11. Fig. 8 is a top perspective view of the structure obtained by placing the first flexible interconnect structure 14a of the semiconductor package 1 on the insulating layer 23. A cross-sectional view taken along a line A-A is Fig. 6. As illustrated in Fig. 6, the first flexible interconnect structure 14a is placed on the insulating layer 23, and the second flexible interconnect structure 14b is placed on the semiconductor chip 11. The first flexible interconnect structure 14a can be placed anywhere within the movable range of the first flexible interconnect structure 14a, thereby imposing no restriction on the design of interconnect patterns in the container area 29.

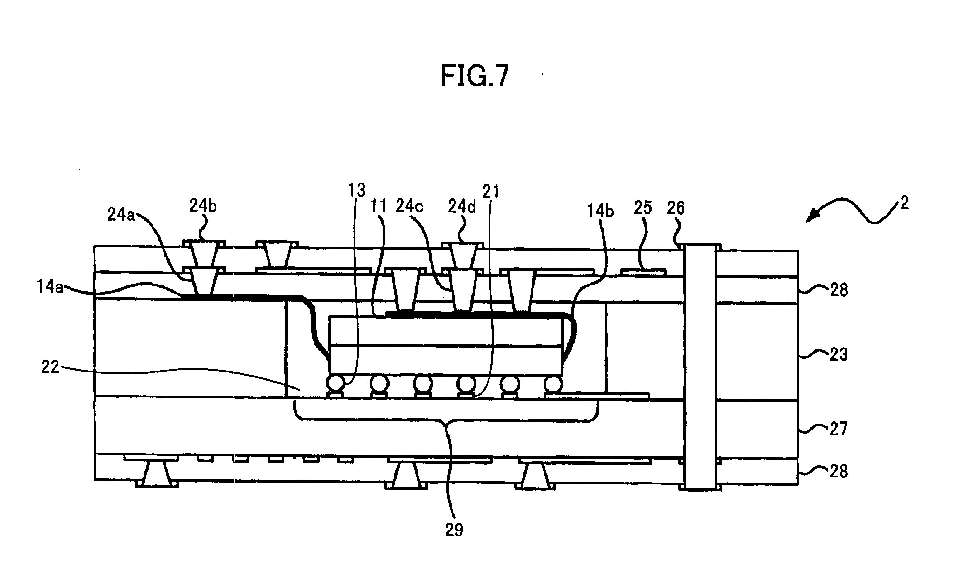

As illustrated in Fig. 7, the semiconductor package 1 in the container area 29 is sealed with the sealing member 22. As previously described, the flow of resin or embedded resin used for forming the insulating layer 28 may be utilized to form the sealing member 22. The insulating layer 28 is placed on the sealing member 22, the insulating layer 23, and the first flexible interconnect structure 14a, followed by forming a copper film on the insulating layer 28. A mask is then formed on the copper film to perform a patterning process to form the interior interconnect layer 25. A laser beam is then used to make a hole through the insulating layer 28 and the interior interconnect layer 25 at the position of a terminal of the first flexible interconnect structure 14a, followed by performing a copper plating process, for example, to form the via 24a. Concurrently, the laser beam is used to make holes through the sealing member 22, the insulating layer 28, and the interior interconnect layer 25 at the positions of terminals of the second flexible interconnect structure 14b, followed by performing a copper plating process to form the vias 24c. Then, the surface interconnect layer 26 is formed by performing a manufacturing step similar to the manufacturing step of making the interior interconnect layer 25. In place of the method of providing electrical connections by applying copper plating to laser holes, electrical connections may be provided by filling the laser holes with conductive paste. Alternatively, electrical connections between the interior interconnect layer 25 and the flexible interconnect structures 14a and 14b may be provided by forming metal bumps on the copper film and then making these bumps penetrate the insulating layer 28. Any of these methods may be selected according to manufacturing conditions.

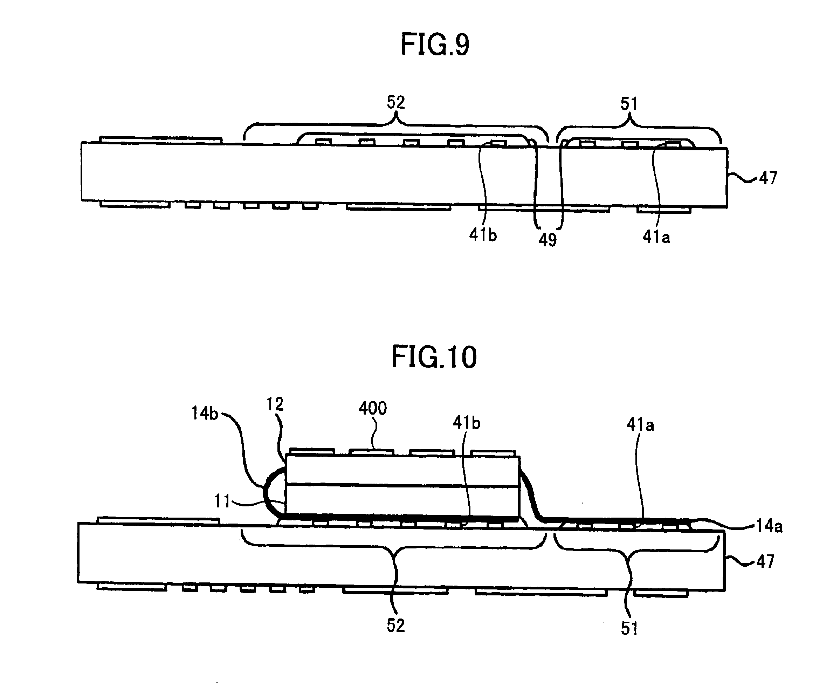

In the following, a description will be given of a method of making a printed circuit board according to a sixth embodiment. Fig. 9 through Fig. 12 are drawings illustrating the steps of manufacturing the printed circuit board according to the present embodiment. It may be noted that a description will be omitted of the same or similar process steps as those of the fifth embodiment.

As illustrated in Fig. 9, interconnect patterns are formed on the insulating layer 47. The interconnect patterns include the terminal pads 41a to be connected to the first flexible interconnect structure 14a, and also include the terminal pads 41b to be connected to the second flexible interconnect structure 14b. Although not illustrated, electrical connections with the pads 41a and 41b are provided through a conductive structure. Examples of such a conductive structure include: anisotropic conductive paste, anisotropic conductive adhesive, an anisotropic conductive film, metal bumps, solder paste, or the like, which is placed in the first area 51 and the second area (i.e., container area) 52 according to the selected mounting method. Although not illustrated, the element 47 may be a single insulating layer with conductive bodies on the front and back surfaces thereof electrically connectable through vias, or may be a structure including plural insulating layers and conductive layers with internal electrical connections.

As illustrated in Fig. 10, then, the semiconductor package 1 is placed with the rigid interconnect structure 12 facing upward, i.e., with electrodes 400 of the rigid interconnect structure 12 facing upward. In so doing, the second flexible interconnect structure 14b of the semiconductor package 1 is wrapped around the semiconductor chip 11. The conductive points of the second flexible interconnect structure 14b are then electrically connected to the terminal pads 41b. Further, the first flexible interconnect structure 14a is placed in the first area 41. The conductive points of the first flexible interconnect structure 14a are then electrically connected to the terminal pads 41a. The semiconductor package 1 arranged as described above has the semiconductor chip 11 facing downward to be opposed to the insulating layer 47 as illustrated in Fig. 10. Also, the first flexible interconnect structure 14a and the second flexible interconnect structure 14b are connected to the terminal pads 41a and the terminal pads 41b, respectively, through an anisotropic conductive adhesive agent or the like. Portions of the conductive member 49 that are not supposed to provide electrical connections may maintain an insulating property.

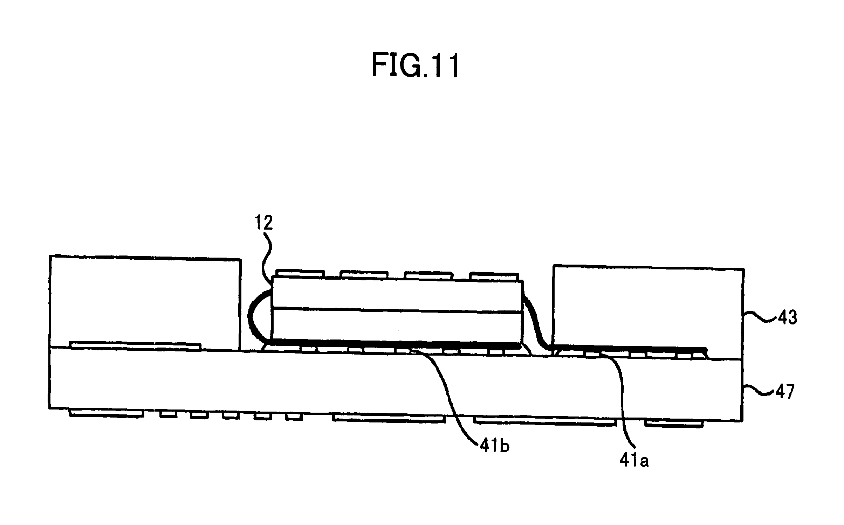

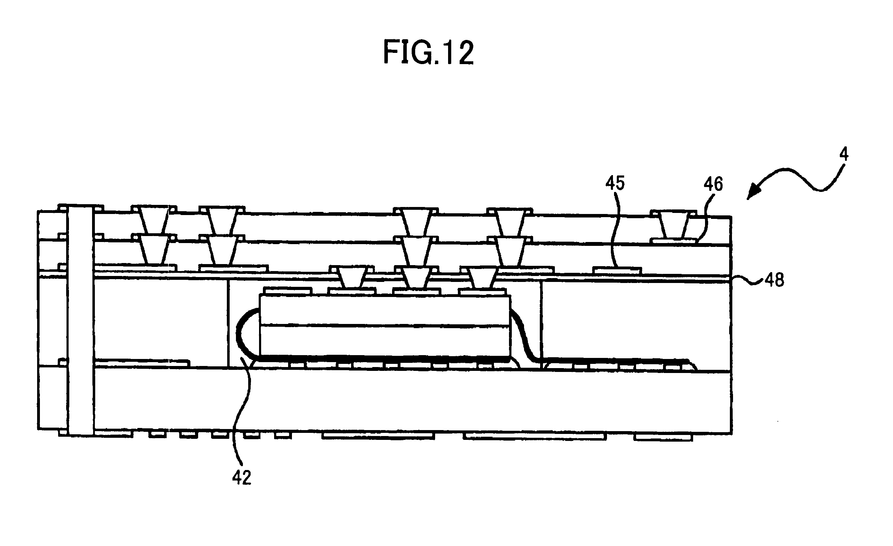

As illustrated in Fig. 11, then, the insulating layer 43 is provided around the semiconductor package 1, with the semiconductor package 1 left exposed. Although not illustrated, the layer 43 may be a single insulating layer, or may be a structure including plural insulating layers and conductive layers with internal electrical connections. As illustrated in Fig. 12, the semiconductor package 1 is sealed with the sealing member 42, followed by forming the insulating layer 48, the vias, and the interior interconnect layers 45 and 46 by use of process steps similar to those used in the fifth embodiment.

As described above, the method of making a printed circuit board according to the present embodiment may allow the semiconductor package 1 to be easily mounted even when the terminal pads 41a are situated in the first area 51, as long as these pads are situated within the movable range of the first flexible interconnect structure 14a. Instead of placing the first flexible interconnect structure 14a in the first area 51, the first flexible interconnect structure 14a may be placed between the insulating layer 43 and the insulating layer 48. In such a case, process steps similar to those of the fifth embodiment may be performed. With this arrangement, vias may be formed between the first flexible interconnect structure 14a and the interior interconnect layer 45 according to need.

In the semiconductor package 1 of the present embodiment, the first flexible interconnect structure 14a and the second flexible interconnect structure 14b are connected to two lateral faces of the rigid interconnect structure 12. When there is a need to provide a large number of electrical connections, the flexible interconnect structures 14 may be provided to extend from all the lateral faces of the rigid interconnect structure 12. With such an arrangement, the shortening of pitches of the electrodes 400 may be suppressed even when the number of connection pins is increased. Further, a plurality of flexible interconnect structures 14 may be provided to one lateral face of the rigid interconnect structure 12. In this manner, the positions and numbers of the flexible interconnect structures 14 may be selected as appropriate by taking into account interconnect patterns in the first area 51.

The printed circuit boards 2 through 4 (Figs. 2 through 4) described heretofore are examples only. The structures of these embodiments may be selectively combined as appropriate according to design specifications.

The printed circuit boards 2 through 4 (Figs. 2 through 4) of the disclosed embodiments may be implemented together with desired functions provided by electronic components, connectors, sockets, cooling structures, or the like, and may serve as an electric apparatus as a whole.

A print circuit board of the disclosed embodiments may be used in electronic apparatuses such as personal computers, portable phones, digital cameras, or the like, which is implemented by using a functional mounted substrate unit that is formed by mounting passive components and active components on the disclosed multilayer print circuit board.

According to at least one embodiment, the specifics of interconnect patterns such as line widths, line intervals, pad sizes, pad intervals, and the like can be designed without restriction imposed by the area size of a rigid interconnect structure.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention.

## Claims

1. A multilayer printed circuit board (2, 3, 4), comprising:
an interior interconnect layer (25, 35, 36); and
a semiconductor package (1) embedded within the said multilayer printed circuit board, **characterized in that** it includes a rigid interconnect structure (12) connected to a semiconductor chip (11) and a flexible interconnect structure (14) whose distal end is a free end,
wherein the rigid interconnect structure (12) and the flexible interconnect structure (14) constitute a rigid-flex substrate and
wherein the flexible interconnect structure and the interior interconnect layer are electrically connected to each other.

2. The print circuit board (2, 3, 4) as claimed in claim 1, wherein the flexible interconnect structure extends outwardly from a container area containing the semiconductor package to be electrically connected to the interior interconnect layer.

3. The print circuit board (2, 3, 4) as claimed in claim 1, wherein the semiconductor package includes a semiconductor chip, and wherein the flexible interconnect structure is placed in direct contact with a surface of the semiconductor chip, and is electrically connected to the interior interconnect layer through a via.

4. The print circuit board (2, 3, 4) as claimed in claim 1, wherein the semiconductor package includes a semiconductor chip, and wherein the flexible interconnect structure is placed above the semiconductor chip with an intervening sealing member situated therebetween, and is electrically connected to the interior interconnect layer.

5. The print circuit board (2, 3, 4) as claimed in claim 1, wherein the flexible interconnect structure includes a portion thereof connected through a conductive member to a terminal pad situated outside a container area containing the semiconductor package.

6. A method of making a multilayer printed circuit board (2, 3, 4) including an interior interconnect layer (25, 35, 36), comprising:
placing a semiconductor package (1) on a substrate (27, 37) having a conductive pad formed thereon such that the semiconductor package is aligned with the conductive pad, the semiconductor package including a rigid interconnect structure (12) connected to a semiconductor chip (11) and a flexible interconnect structure whose distal end is a free end; wherein the rigid interconnect structure (12) and the flexible interconnect structure (14) constitute a rigid-flex substrate, and
providing an insulating layer (23, 33) around the semiconductor package; and
providing an electrical connection between the flexible interconnect structure and the interior interconnect layer formed on the insulating layer.

7. The method as claimed in claim 6, comprising:
placing a portion of the flexible interconnect structure in direct contact with a surface of a semiconductor chip of the semiconductor package; and
providing an electrical connection through a via between the portion of the flexible interconnect structure and the interior interconnect layer.

8. The method as claimed in claim 6, comprising:
placing a portion of the flexible interconnect structure above a surface of a semiconductor chip of the semiconductor package, with an intervening sealing member situated therebetween; and
providing an electrical connection between the portion of the flexible interconnect structure and the interior interconnect layer.

9. The method as claimed in claim 6, comprising connecting a portion of the flexible interconnect structure through a conductive member to a terminal pad situated outside a container area containing the semiconductor package.

10. An electronic apparatus comprising:
an enclosure;
a multilayer printed circuit board according to any of claims 1 to 5.

## Patentansprüche

1. Mehrschichtige gedruckte Schaltungsplatte (2, 3, 4), umfassend:
eine innere Zwischenverbindungsschicht (25, 35, 36); und
eine Halbleiterpackung (1), die in der mehrschichtigen gedruckten Schaltungsplatte eingebettet ist, **dadurch gekennzeichnet, dass** sie eine starre Zwischenverbindungsstruktur (12) enthält, die mit einem Halbleiterchip (11) verbunden ist, und eine flexible Zwischenverbindungsstruktur (14), deren distales Ende ein freies Ende ist,
bei der die starre Zwischenverbindungsstruktur (12) und die flexible Zwischenverbindungsstruktur (14) ein starrflexibles Substrat bilden und
bei der die flexible Zwischenverbindungsstruktur und die innere Zwischenverbindungsschicht elektrisch miteinander verbunden sind.

2. Gedruckte Schaltungsplatte (2, 3, 4) nach Anspruch 1, bei der sich die flexible Zwischenverbindungsstruktur von einem Behälterbereich, der die Halbleiterpackung enthält, nach außen erstreckt, um mit der inneren Zwischenverbindungsschicht elektrisch verbunden zu sein.

3. Gedruckte Schaltungsplatte (2, 3, 4) nach Anspruch 1, bei der die Halbleiterpackung einen Halbleiterchip enthält und bei der die flexible Zwischenverbindungsstruktur in direktem Kontakt mit einer Oberfläche des Halbleiterchips angeordnet ist und mit der inneren Zwischenverbindungsschicht durch einen Durchgang elektrisch verbunden ist.

4. Gedruckte Schaltungsplatte (2, 3, 4) nach Anspruch 1, bei der die Halbleiterpackung einen Halbleiterchip enthält und bei der die flexible Zwischenverbindungsstruktur über dem Halbleiterchip mit einem dazwischenliegenden Abdichtungsglied, das zwischen ihnen positioniert ist, angeordnet ist und mit der inneren Zwischenverbindungsschicht elektrisch verbunden ist.

5. Gedruckte Schaltungsplatte (2, 3, 4) nach Anspruch 1, bei der die flexible Zwischenverbindungsstruktur einen Abschnitt enthält, der durch ein leitfähiges Glied mit einem Anschlusskissen verbunden ist, das außerhalb eines Behälterbereiches positioniert ist, der die Halbleiterpackung enthält.

6. Verfahren zum Herstellen einer mehrschichtigen gedruckten Schaltungsplatte (2, 3, 4), die eine innere Zwischenverbindungsschicht (25, 35, 36) enthält, umfassend:
Anordnen einer Halbleiterpackung (1) auf einem Substrat (27, 37), auf dem ein leitfähiges Kissen gebildet ist, so dass die Halbleiterpackung mit dem leitfähigen Kissen ausgerichtet ist, welche Halbleiterpackung eine starre Zwischenverbindungsstruktur (12) enthält, die mit einem Halbleiterchip (11) verbunden ist, und eine flexible Zwischenverbindungsstruktur (14), deren distales Ende ein freies Ende ist; bei der die starre Zwischenverbindungsstruktur (12) und die flexible Zwischenverbindungsstruktur (14) ein starr-flexibles Substrat bilden, und
Vorsehen einer Isolierschicht (23, 33) um die Halbleiterpackung herum; und
Vorsehen einer elektrischen Verbindung zwischen der flexiblen Zwischenverbindungsstruktur und der inneren Zwischenverbindungsschicht, die auf der Isolierschicht gebildet ist.

7. Verfahren nach Anspruch 6, umfassend:
Anordnen eines Abschnittes der flexiblen Zwischenverbindungsstruktur in direktem Kontakt mit einer Oberfläche eines Halbleiterchips der Halbleiterpackung; und
Vorsehen einer elektrischen Verbindung durch einen Durchgang zwischen dem Abschnitt der flexiblen Zwischenverbindungsstruktur und der inneren Zwischenverbindungsschicht.

8. Verfahren nach Anspruch 6, umfassend:
Anordnen eines Abschnittes der flexiblen Zwischenverbindungsstruktur über einer Oberfläche eines Halbleiterchips der Halbleiterpackung, mit einem dazwischenliegenden Abdichtungsglied, das zwischen ihnen positioniert ist; und
Vorsehen einer elektrischen Verbindung zwischen dem Abschnitt der flexiblen Zwischenverbindungsstruktur und der inneren Zwischenverbindungsschicht.

9. Verfahren nach Anspruch 6, mit dem Verbinden eines Abschnittes der flexiblen Zwischenverbindungsstruktur durch ein leitfähiges Glied mit einem Anschlusskissen, das außerhalb eines Behälterbereiches positioniert ist, der die Halbleiterpackung enthält.

10. Elektrische Vorrichtung, umfassend:
ein Gehäuse;
eine mehrschichtige gedruckte Schaltungsplatte nach einem der Ansprüche 1 bis 5.

## Revendications

1. Carte de circuit imprimé multicouche (2, 3, 4), comprenant :
une couche d'interconnexion intérieure (25, 35, 36) ; et
un boîtier de semi-conducteur (1) intégré dans ladite carte de circuit imprimé multicouche, **caractérisée en ce qu'**elle comprend une structure d'interconnexion rigide (12) connectée à une puce semi-conductrice (11) et une structure d'interconnexion souple (14) dont l'extrémité distale est une extrémité libre,
dans laquelle la structure d'interconnexion rigide (12) et la structure d'interconnexion souple (14) constituent un substrat rigide-souple, et
dans laquelle la structure d'interconnexion souple et la couche d'interconnexion intérieure sont connectées électriquement l'une à l'autre.

2. Carte de circuit imprimé (2, 3, 4) selon la revendication 1, dans laquelle la structure d'interconnexion souple s'étend à l'extérieur d'une zone de contenant qui contient le boîtier de semi-conducteur à connecter électriquement à la couche d'interconnexion intérieure.

3. Carte de circuit imprimé (2, 3, 4) selon la revendication 1, dans laquelle le boîtier de semi-conducteur comprend une puce semi-conductrice, et dans laquelle la structure d'interconnexion souple est placée en contact direct avec une surface de la puce semi-conductrice, et est connectée électriquement à la couche d'interconnexion intérieure par l'intermédiaire d'un trou d'interconnexion.

4. Carte de circuit imprimé (2, 3, 4) selon la revendication 1, dans laquelle le boîtier de semi-conducteur comprend une puce semi-conductrice, et dans laquelle la structure d'interconnexion souple est placée au-dessus de la puce semi-conductrice avec un élément d'étanchéité intermédiaire situé entre elles, et est connectée électriquement à la couche d'interconnexion intérieure.

5. Carte de circuit imprimé (2, 3, 4) selon la revendication 1, dans laquelle la structure d'interconnexion souple comprend une partie de celle-ci connectée par l'intermédiaire d'un élément conducteur à une pastille de borne située à l'extérieur d'une zone de contenant qui contient le boîtier de semi-conducteur.

6. Procédé de fabrication d'une carte de circuit imprimé multicouche (2, 3, 4) comprenant une couche d'interconnexion intérieure (25, 35, 36), comprenant :
le placement d'un boîtier de semi-conducteur (1) sur un substrat (27, 37) ayant une pastille conductrice formée sur celui-ci de sorte que le boîtier de semi-conducteur soit aligné avec la pastille conductrice, le boîtier de semi-conducteur comprenant une structure d'interconnexion rigide (12) connectée à une puce semi-conductrice (11) et une structure d'interconnexion souple dont l'extrémité distale est une extrémité libre ; dans lequel la structure d'interconnexion rigide (12) et la structure d'interconnexion souple (14) constituent un substrat rigide-souple, et
la prévision d'une couche isolante (23, 33) autour du boîtier de semi-conducteur ; et
la réalisation d'une connexion électrique entre la structure d'interconnexion souple et la couche d'interconnexion intérieure formée sur la couche isolante.

7. Procédé selon la revendication 6, comprenant :
le placement d'une partie de la structure d'interconnexion souple en contact direct avec une surface d'une puce semi-conductrice du boîtier de semi-conducteur ; et
la réalisation d'une connexion électrique par l'intermédiaire d'un trou d'interconnexion entre la partie de la structure d'interconnexion souple et la couche d'interconnexion intérieure.

8. Procédé selon la revendication 6, comprenant :
le placement d'une partie de la structure d'interconnexion souple au-dessus d'une surface d'une puce semi-conductrice du boîtier de semi-conducteur, avec un élément d'étanchéité intermédiaire situé entre elles ; et
la réalisation d'une connexion électrique entre la partie de la structure d'interconnexion souple et la couche d'interconnexion intérieure.

9. Procédé selon la revendication 6, comprenant la connexion d'une partie de la structure d'interconnexion souple par l'intermédiaire d'un élément conducteur à une pastille de borne située à l'extérieur d'une zone de contenant qui contient le boîtier de semi-conducteur.

10. Appareil électronique comprenant :
une enceinte ;
une carte de circuit imprimé multicouche selon l'une quelconque des revendications 1 à 5.
